# EUROPEAN PATENT APPLICATION

(11) **EP 4 838 234 A1**
(43) Date of publication of application: **11.11.2026**
(21) Application number: 26154039.7
(22) Date of filing: 26.01.2026
(51) Int. Cl.: G01R 31/28

(54) **WAFER TEST APPARATUS FOR PROVIDING ISOLATED ENVIRONMENT**

(30) Priority: 09.05.2025 US 202563802622 P; 08.08.2025 CN 202511108398
(71) Applicant: Vuette Pte. Ltd., 058357 Singapore (SG)
(72) Inventor: LOU, Choon-Leong, 470605 Singapore (SG); LIM, Ban-Ban, 678187 Singapore (SG)
(74) Representative: Viering, Jentschura & Partner mbB Patent- und Rechtsanwälte

(57) **Abstract**

A wafer test apparatus for providing an isolated environment includes a sealed chamber (5), a carrier (6), and a platform (7). The sealed chamber (5) includes a base (51), a first housing (53) arranged on the base (51), and a second housing (55) arranged on an end of the first housing (53) away from the base (51). The second housing (55) is movable relative to the first housing (53) along a movement direction (Z). The carrier (6) is disposed on the base (51), is arranged in the first housing (53), and holds a device under test (4). The platform (7) is arranged above the sealed chamber (5), and holds a probe card (2). When the probe card (2) is used to perform a probe test program on the device under test (4), the second housing (55) moves along the movement direction (Z) away from the base (51), so that the first housing (53), the second housing (55), the platform (7), and the probe card (2) jointly define a sealed isolation space (59).

## Description

### FIELD OF THE INVENTION

The present invention relates to a wafer test apparatus for providing an isolated environment, and more particularly to a wafer test apparatus for providing an isolated environment during pressure control or temperature control.

### BACKGROUND OF THE INVENTION

In the existing technology, a pressure chamber is provided between a probe card and a semiconductor component for high voltage semiconductor testing. Multiple gas channels are provided in the probe card to deliver gas to the pressure chamber for pressurization. A probe station holds the semiconductor component under test. The pressure chamber for a portion of the probe card and the semiconductor component under test is configured in a probe carrier through a cylindrical sleeve and a sealing ring, so that the pressure chamber can be pressurized during high voltage testing and point discharge is suppressed.

The point discharge during the high voltage testing can cause leakage, thereby reducing test accuracy and potentially damaging the probe card or the test apparatus. Increasing an atmospheric pressure is a common and effective approach to suppress the point discharge. However, in the existing technology, a pressurized space that can be provided is limited to the pressure chamber, and the pressure chamber can only be provided for a portion of the semiconductor component under test before testing. As a result, a considerable amount of time is required for testing the entire semiconductor component under test.

### SUMMARY OF THE INVENTION

In response to the above-referenced technical inadequacies, the present invention provides a wafer test apparatus for providing an isolated environment, so that a larger testing area for a semiconductor component under test is provided in an isolated environment, and test efficiency can be improved.

In order to solve the above-mentioned problems, one of the technical aspects adopted by the present invention is to provide a wafer test apparatus for providing an isolated environment, which is suitable for providing a sealed isolation space when performing a probe test program on a device under test using a probe card. The wafer test apparatus for providing the isolated environment includes a sealed chamber, a carrier, and a platform. The sealed chamber includes a base, a first housing, and a second housing. The first housing is arranged on the base, the second housing is arranged on an end of the first housing away from the base, and the second housing is movable relative to the first housing along a movement direction toward or away from the base. The carrier is disposed on the base, and is arranged in the first housing. The carrier is configured to hold the device under test. The platform is arranged above the sealed chamber, and the platform is configured to hold the probe card. When the probe card is used to perform the probe test program on the device under test, the second housing moves along the movement direction away from the base, so that the first housing, the second housing, the platform, and the probe card are arranged to define the sealed isolation space.

In one of the possible or preferred embodiments, the wafer test apparatus for providing the isolated environment further includes at least one first sealing member, and the first sealing member is arranged between the second housing and the platform. When the probe card is used to perform the probe test program on the device under test, the first sealing member is compressed by the second housing and the platform.

In one of the possible or preferred embodiments, the first housing includes a pressing plate at an upper end of the first housing away from the base, the second housing includes a stop plate at a lower end of the second housing adjacent to the first housing, and a second sealing member is arranged between the pressing plate and the stop plate. When the probe card is used to perform the probe test program on the device under test, the second sealing member is compressed by the pressing plate and the stop plate.

In one of the possible or preferred embodiments, the pressing plate and the stop plate are configured in a corresponding horizontal orientation or a corresponding inclined orientation.

In one of the possible or preferred embodiments, the second housing includes a top plate, a quantity of the at least one first sealing member is two, and the two first sealing members are arranged between the top plate and the platform.

In one of the possible or preferred embodiments, the platform includes a third sealing member, the third sealing member is arranged between the platform and the probe card, and the third sealing member is compressed by the platform and the probe card.

In one of the possible or preferred embodiments, the second housing is in close contact with the platform through a motor thrust connection, a mechanical thrust connection, a pneumatic thrust connection, or a structural connection.

In one of the possible or preferred embodiments, the structural connection is a snap-fit connection.

In one of the possible or preferred embodiments, when the probe card is used to perform the probe test program on the device under test, the sealed isolation space is configured as a test environment having a pressure higher than an atmospheric pressure.

In one of the possible or preferred embodiments, the sealed isolation space is filled with air, nitrogen, or an inert gas.

In one of the possible or preferred embodiments, when the carrier is loaded or unloaded with the device under test, the second housing and the platform are separated from each other.

In one of the possible or preferred embodiments, the movement direction is perpendicular to a Z-axis direction of the base.

In one of the possible or preferred embodiments, the probe card includes a probe. When the probe card is used to perform the probe test program on the device under test, the probe, the device under test, and the carrier are placed in the sealed isolation space, so that the atmospheric pressure to which the probe, the device under test, and the carrier are each subjected is the same.

In one of the possible or preferred embodiments, a chamfer is provided between the first housing and the pressing plate, and the chamfer is in contact with the second sealing member to enhance airtightness.

In one of the possible or preferred embodiments, a chamfer is provided between the second housing and the stop plate, and the chamfer is in contact with the second sealing member to enhance airtightness.

In one of the possible or preferred embodiments, when the probe card is used to perform the probe test program on the device under test, the sealed isolation space is configured to provide a test temperature.

In one of the possible or preferred embodiments, upon completion of the probe test program on the device under test by the probe card, the second housing moves along the movement direction toward the base, so that the carrier moves the device under test out of the sealed isolation space.

One of the beneficial effects of the present invention is that the wafer test apparatus for providing the isolated environment provided by the present invention includes the sealed chamber, the carrier, and the platform. The sealed chamber includes the base, the first housing, and the second housing. The first housing is arranged on the base, the second housing is arranged on the end of the first housing away from the base, and the second housing is movable relative to the first housing along the movement direction toward or away from the base. The carrier is disposed on the base, and is arranged in the first housing. The carrier is configured to hold the device under test. The platform is arranged above the sealed chamber, and the platform is configured to hold the probe card. When the probe card is used to perform the probe test program on the device under test, the second housing moves along the movement direction away from the base, so that the first housing, the second housing, the platform, and the probe card are arranged to define the sealed isolation space. Through the technical features of the present invention, the sealed isolation space is provided, so that a larger testing area for a semiconductor component under test is provided in an isolated environment, and test efficiency can be improved.

These and other aspects of the present invention will become apparent from the following description of the embodiment taken in conjunction with the following drawings and their captions, although variations and modifications therein may be effected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a schematic cross-sectional view of a wafer test apparatus for providing an isolated environment according to a first embodiment of the present invention;
FIG. 2 is a schematic cross-sectional view of the wafer test apparatus for providing the isolated environment according to a second embodiment of the present invention;
FIG. 3 is another schematic cross-sectional view of the wafer test apparatus for providing the isolated environment according to the second embodiment of the present invention;
FIG. 4 is yet another schematic cross-sectional view of the wafer test apparatus for providing the isolated environment according to the second embodiment of the present invention;
FIG. 5 is a schematic three-dimensional view of a first housing and a second housing according to the first embodiment of the present invention;
FIG. 6 is a schematic cross-sectional view of the wafer test apparatus for providing the isolated environment according to a third embodiment of the present invention;
FIG. 7 is a schematic cross-sectional view of the wafer test apparatus for providing the isolated environment according to a fourth embodiment of the present invention;
FIG. 8 is a schematic cross-sectional view of the wafer test apparatus for providing the isolated environment according to a fifth embodiment of the present invention;
FIG. 9 is a schematic view showing cooperation between the first housing and the second housing according to an embodiment of the present invention;
FIG. 10 is another schematic view showing the cooperation between the first housing and the second housing according to the embodiment of the present invention;
FIG. 11 is yet another schematic view showing the cooperation between the first housing and the second housing according to the embodiment of the present invention; and
FIG. 12 is still another schematic view showing the cooperation between the first housing and the second housing according to the embodiment of the present invention.

### DETAILED DESCRIPTION OF THE EXEMPLARY EMBODIMENTS

The present invention is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [Embodiments]

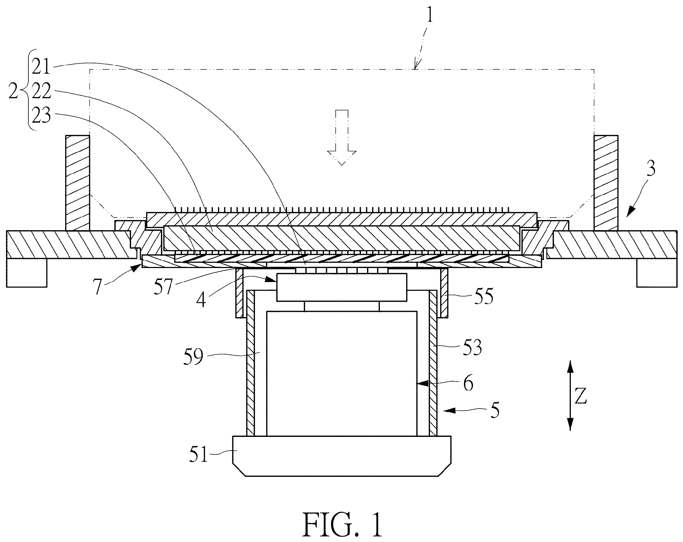

Referring to FIG. 1, FIG. 1 is a schematic cross-sectional view of a wafer test apparatus for providing an isolated environment according to a first embodiment of the present invention. The present invention provides the wafer test apparatus for providing the isolated environment, which is suitable for providing a sealed isolation space 59 when performing a probe test program on a device under test 4 using a probe card 2. The probe card 2 can be mounted on a test machine 1 through a probe station 3. The probe card 2 can include probes 21, a reinforcement member 22, and a substrate 23. The probes 21 are disposed on the substrate 23, and the reinforcement member 22 is connected to the substrate 23 to enhance a strength of the substrate 23. The wafer test apparatus for providing the isolated environment includes a sealed chamber 5, a carrier 6, and a platform 7.

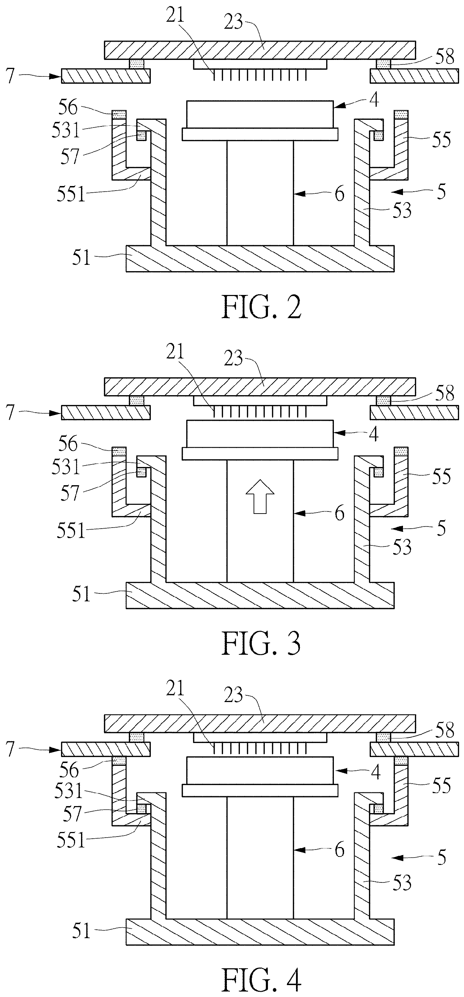

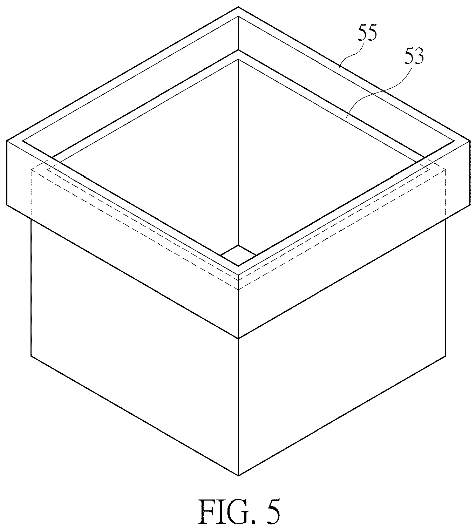

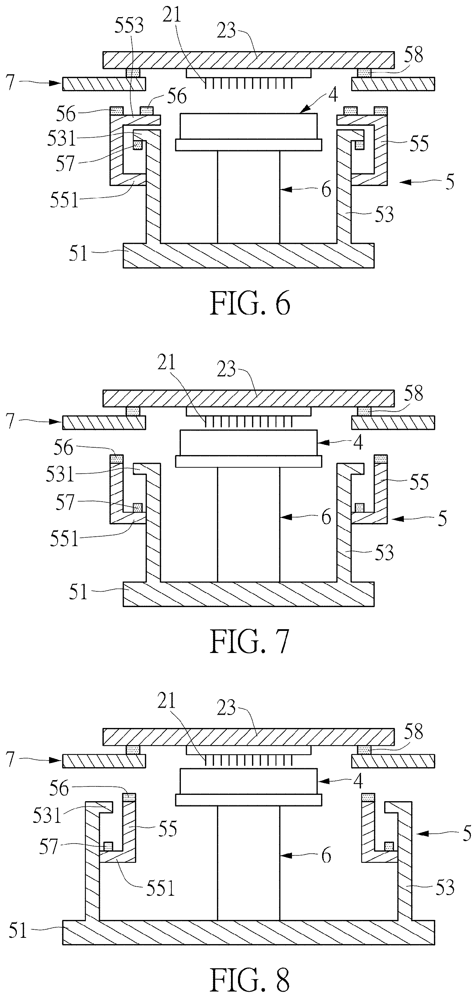

Referring to FIG. 2 to FIG. 4, FIG. 2 to FIG. 4 are schematic cross-sectional views of the wafer test apparatus for providing the isolated environment according to a second embodiment of the present invention. Referring to FIG. 6 to FIG. 8, FIG. 6 to FIG. 8 are schematic cross-sectional views of the wafer test apparatus for providing the isolated environment according to a third embodiment, a fourth embodiment, and a fifth embodiment of the present invention, respectively. The sealed chamber 5 includes a base 51, a first housing 53, and a second housing 55. The first housing 53 and the second housing 55 are hollow housings, and shapes of the first housing 53 and the second housing 55 are not limited. As shown in FIG. 5, in the present embodiment, both the first housing 53 and the second housing 55 are square housings, and a height of the second housing 55 is less than a height of the first housing 53. The first housing 53 and the second housing 55 are nested together, and the second housing 55 can be arranged on an outer side of the first housing 53 (as shown in FIG. 2 to FIG. 7) or on an inner side of the first housing 53 (as show in FIG. 8). The first housing 53 can be arranged on the base 51. A bottom end of the first housing 53 can be arranged on the base 51. The bottom end of the first housing 53 can be appropriately fixed to the base 51. The second housing 55 can be arranged on an end of the first housing 53 away from the base 51. That is, the second housing 55 can be arranged on an upper end of the first housing 53. As shown in FIG. 1, the second housing 55 can move relative to the first housing 53 along a movement direction Z toward or away from the base 51. The movement direction Z is perpendicular to a Z-axis direction of the base 51.

The carrier 6 is disposed on the base 51, and the carrier 6 is arranged in the first housing 53. The carrier 6 holds the device under test 4. The platform 7 is arranged above the sealed chamber 5, and holds the probe card 2. When the probe card 2 is used to perform the probe test program on the device under test 4, the probes 21, the device under test 4, and the carrier 6 are placed in the sealed isolation space 59, so that the probes 21, the device under test 4, and the carrier 6 are subjected to the same atmospheric pressure.

As shown in FIG. 1, when the probe card 2 is used to perform the probe test program on the device under test 4, the second housing 55 moves along the movement direction Z away from the base 51, so that the first housing 53, the second housing 55, the platform 7, and the probe card 2 are arranged to define the sealed isolation space 59.

Suitable sealing members can be correspondingly provided between the first housing 53 and the second housing 55, and between the second housing 55 and the platform 7 to enhance airtightness. Referring to FIG. 2 to FIG. 4 and FIG. 6 to FIG. 8, one or two first sealing members 56 can be provided between the second housing 55 and the platform 7 in the present invention. The first sealing member 56 can be made of rubber or similar materials. The first sealing member 56 can be annular in shape. The first sealing member 56 can be provided at an upper end of the second housing 55. As shown in FIG. 2 to FIG. 4, FIG. 7, and FIG. 8, one first sealing member 56 is provided between the second housing 55 and the platform 7, and, as shown in FIG. 6, two first sealing members 56 are provided between the second housing 55 and the platform 7, which provides better airtightness. When the probe card 2 is used to perform the probe test program on the device under test 4, the first sealing member 56 is compressed by the second housing 55 and the platform 7, so that good airtightness is maintained between the second housing 55 and the platform 7. As shown in FIG. 6, the second housing 55 can further include a top plate 553, and the top plate 553 is arranged at the upper end of the second housing 55. The top plate 553 can be used to hold the two first sealing members 56, so that the two sealing members 56 are arranged between the top plate 553 and the platform 7.

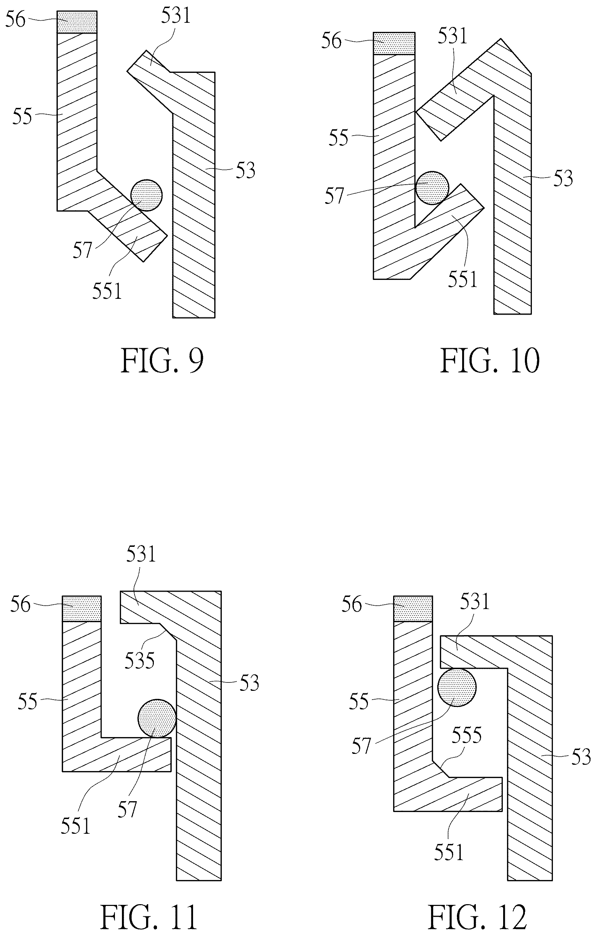

As shown in FIG. 2 to FIG. 4, FIG. 6, and FIG. 7, the first housing 53 can include a pressing plate 531. The pressing plate 531 can be arranged at the upper end of the first housing 53 away from the base 51, and protrude outward. The second housing 55 can include a stop plate 551. The stop plate 551 can be arranged at a lower end of the second housing 55 adjacent to the first housing 53, and protrude inward. A second sealing member 57 can be provided between the pressing plate 531 and the stop plate 551. The second sealing member 57 can be made of rubber or similar materials. The second sealing member 57 can be annular in shape. The second sealing member 57 can be fixed to a bottom side of the pressing plate 531 or a top side of the stop plate 551. As shown in FIG. 2 to FIG. 4 and FIG. 6 to FIG. 8, the pressing plate 531 and the stop plate 551 can be configured in a corresponding horizontal orientation, and, as shown in FIG. 9 and FIG. 10, the pressing plate 531 and the stop plate 551 can also be configured in a corresponding inclined orientation. When the probe card 2 is used to perform the probe test program on the device under test 4, the second sealing member 57 is compressed by the pressing plate 531 and the stop plate 551, so that good airtightness is maintained between the first housing 53 and the second housing 55.

As shown in FIG. 11, a chamfer 535 is provided between the first housing 53 and the pressing plate 531, and the chamfer 535 can be arranged on an inner side of the first housing 53 adjacent to the pressing plate 531. The chamfer 535 can be an inclined plane. The chamfer 535 can be in contact with the second sealing member 57 to enhance the airtightness. As shown in FIG. 12, a chamfer 555 can also be provided between the second housing 55 and the stop plate 551, and the chamfer 555 can be arranged on an inner side of the second housing 55 adjacent to the stop plate 551. The chamfer 555 can be an inclined plane. The chamfer 555 can be in contact with the second sealing member 57 to enhance the airtightness.

As shown in FIG. 2 to FIG. 4 and FIG. 6 to FIG. 8, the platform 7 can further include a third sealing member 58. The third sealing member 58 can be made of rubber or similar materials. The third sealing member 58 can be annular in shape. The third sealing member 58 is arranged between the platform 7 and the probe card 2. The third sealing member 58 is compressed by the platform 7 and the probe card 2, so that good airtightness is maintained between the platform 7 and the probe card 2.

The second housing 55 is in close contact with the platform 7 through a motor thrust connection, a mechanical thrust connection, a pneumatic thrust connection, or a structural connection. The structural connection can be a snap-fit connection, thereby pushing the second housing 55 upward to be in close contact with the platform 7. When the probe card 2 is used to perform the probe test program on the device under test 4, the sealed isolation space 59 is configured as a test environment with a pressure higher than the atmospheric pressure. The sealed isolation space 59 can be filled with air, nitrogen, or an inert gas. When the carrier 6 is loaded or unloaded with the device under test 4, the second housing 55 and the platform 7 are separated from each other to facilitate loading or unloading the device under test 4. When the probe card 2 is used to perform the probe test program on the device under test 4, the sealed isolation space 59 can also be configured to provide a test temperature.

The present invention can be used in applications such as pressure control (testing an air pressure) and temperature control. Further, the present invention can be used in the application of controlling test temperatures, such as an ambient temperature, a high temperature, and a low temperature. The present invention is also beneficial for providing the test temperatures since temperature control is more readily achievable with an enclosed space. Further, when the probe card and the device under test are made of materials having an identical coefficient of thermal expansion, the deviation between the probes and the device under test due to thermal expansion can be minimized by controlling the ambient temperature.

### [Beneficial Effects of the Embodiments]

In conclusion, one of the beneficial effects of the present invention is that the wafer test apparatus for providing the isolated environment provided by the present invention includes the sealed chamber, the carrier, and the platform. The sealed chamber includes the base, the first housing, and the second housing. The first housing is arranged on the base, the second housing is arranged on the end of the first housing away from the base, and the second housing is movable relative to the first housing along the movement direction toward or away from the base. The carrier is disposed on the base, and is arranged in the first housing. The carrier is configured to hold the device under test. The platform is arranged above the sealed chamber, and the platform is configured to hold the probe card. When the probe card is used to perform the probe test program on the device under test, the second housing moves along the movement direction away from the base, so that the first housing, the second housing, the platform, and the probe card are arranged to define the sealed isolation space. Through the technical features of the present invention, the sealed isolation space is provided, so that a larger testing area for a semiconductor component under test is provided in an isolated environment, and test efficiency can be improved.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A wafer test apparatus for providing an isolated environment, suitable for providing a sealed isolation space (59) when a probe card (2) is used to perform a probe test program on a device under test (4), **characterized in that** the wafer test apparatus for providing the isolated environment comprises:
a sealed chamber (5) including a base (51), a first housing (53), and a second housing (55), wherein the first housing (53) is arranged on the base (51), the second housing (55) is arranged on an end of the first housing (53) away from the base (51), and the second housing (55) is movable relative to the first housing (53) along a movement direction (Z) toward or away from the base (51);
a carrier (6) disposed on the base (51) and arranged in the first housing (53), wherein the carrier (6) is configured to hold the device under test (4); and
a platform (7) arranged above the sealed chamber (5), wherein the platform (7) is configured to hold the probe card (2);
wherein, when the probe card (2) is used to perform the probe test program on the device under test (4), the second housing (55) moves along the movement direction (Z) away from the base (51), so that the first housing (53), the second housing (55), the platform (7), and the probe card (2) are arranged to define the sealed isolation space (59).

2. The wafer test apparatus according to claim 1, further comprising:
at least one first sealing member (56), wherein the first sealing member (56) is arranged between the second housing (55) and the platform (7), and wherein, when the probe card (2) is used to perform the probe test program on the device under test (4), the first sealing member (56) is compressed by the second housing (55) and the platform (7).

3. The wafer test apparatus according to claim 1, wherein the first housing (53) includes a pressing plate (531) at an upper end of the first housing (53) away from the base (51), the second housing (55) includes a stop plate (551) at a lower end of the second housing (55) adjacent to the first housing (53), and a second sealing member (57) is arranged between the pressing plate (531) and the stop plate (551), and wherein, when the probe card (2) is used to perform the probe test program on the device under test (4), the second sealing member (57) is compressed by the pressing plate (531) and the stop plate (551).

4. The wafer test apparatus according to claim 3, wherein the pressing plate (531) and the stop plate (551) are configured in a corresponding horizontal orientation or a corresponding inclined orientation.

5. The wafer test apparatus according to claim 2, wherein the second housing (55) includes a top plate (553), a quantity of the at least one first sealing member (56) is two, and the two first sealing members (56) are arranged between the top plate (553) and the platform (7).

6. The wafer test apparatus according to claim 1, wherein the platform (7) includes a third sealing member (58), the third sealing member (58) is arranged between the platform (7) and the probe card (2), and the third sealing member (58) is compressed by the platform (7) and the probe card (2).

7. The wafer test apparatus according to claim 1, wherein the second housing (55) is in close contact with the platform (7) through a motor thrust connection, a mechanical thrust connection, a pneumatic thrust connection, or a structural connection.

8. The wafer test apparatus according to claim 7, wherein the structural connection is a snap-fit connection.

9. The wafer test apparatus according to claim 1, wherein, when the probe card (2) is used to perform the probe test program on the device under test (4), the sealed isolation space (59) is configured as a test environment having a pressure higher than an atmospheric pressure.

10. The wafer test apparatus according to claim 9, wherein the sealed isolation space (59) is filled with air, nitrogen, or an inert gas.

11. The wafer test apparatus according to claim 1, wherein, when the carrier (6) is loaded or unloaded with the device under test (4), the second housing (55) and the platform (7) are separated from each other.

12. The wafer test apparatus according to claim 1, wherein the movement direction (Z) is perpendicular to a Z-axis direction of the base (51).

13. The wafer test apparatus according to claim 9, wherein the probe card (2) includes a probe (21), and wherein, when the probe card (2) is used to perform the probe test program on the device under test (4), the probe (21), the device under test (4), and the carrier (6) are placed in the sealed isolation space (59), so that the atmospheric pressure to which the probe (21), the device under test (4), and the carrier (6) are each subjected is the same.

14. The wafer test apparatus according to claim 10, wherein the probe card (2) includes a probe (21), wherein, when the probe card (2) is used to perform the probe test program on the device under test (4), the probe (21), the device under test (4), and the carrier (6) are placed in the sealed isolation space (59), so that the atmospheric pressure to which the probe (21), the device under test (4), and the carrier (6) are each subjected is the same.

15. The wafer test apparatus according to claim 4, wherein a chamfer (535) is provided between the first housing (53) and the pressing plate (531), and the chamfer (535) is in contact with the second sealing member (57) to enhance airtightness.

16. The wafer test apparatus according to claim 4, wherein a chamfer (555) is provided between the second housing (55) and the stop plate (551), and the chamfer (555) is in contact with the second sealing member (57) to enhance airtightness.

17. The wafer test apparatus according to claim 1, wherein, when the probe card (2) is used to perform the probe test program on the device under test (4), the sealed isolation space (59) is configured to provide a test temperature.

18. The wafer test apparatus according to claim 1, wherein, upon completion of the probe test program on the device under test (4) by the probe card (2), the second housing (55) moves along the movement direction (Z) toward the base (51), so that the carrier (6) moves the device under test (4) out of the sealed isolation space (59).
